# EUROPÄISCHE PATENTSCHRIFT

(11) **EP 2 364 385 B1**
(45) Veröffentlichungstag und Bekanntmachung des Hinweises auf die Patenterteilung: **29.01.2014**
(21) Anmeldenummer: 09760895.4
(22) Anmeldetag: 01.12.2009
(51) Int. Cl.: D05B 23/00, H01L 31/02

(54) **VERFAHREN ZUM ANBRINGEN FLÄCHIGER ELEKTRONISCHER BAUELEMENTE AUF EINEM FLEXIBLEN FLÄCHENGEBILDE**
METHOD FOR APPLYING FLAT ELECTRONIC COMPONENTS ON A FLEXIBLE PLANE PRODUCT
PROCEDE D'APPLICATION DE COMPOSANTS ELECTRONIQUES PLATS SUR UN PRODUIT AYANT UNE SURFACE PLANE

(30) Priorität: 04.12.2008 CH 18972008
(43) Veröffentlichungstag der Anmeldung: 14.09.2011
(73) Patentinhaber: Forster Rohner AG, 9006 St. Gallen (CH)
(72) Erfinder: FORSTER, Ulrich, CH-9011 St. Gallen (CH); ZIMMERMANN, Jan-Helge, CH-8057 Zürich (CH)
(74) Vertreter: Wenger, René
(86) Internationale Anmeldenummer: PCT/EP2009/066114
(87) Internationale Veröffentlichungsnummer: WO 2010/063697

(56) Entgegenhaltungen:
- WO-A-02/27651
- WO-A-03/052541
- WO-A-03/052875
- CN-A- 101 433 380
- CN-A- 101 756 468
- DE-A1- 10 307 505
- DE-B3- 10 248 388
- DE-U1-202004 000 398
- GB-A- 2 458 664
- JP-A- 10 144 947
- JP-A- 2006 339 683
- JP-A- 2007 189 132
- US-A- 3 130 257

## Beschreibung

Die Erfindung betrifft ein Verfahren zum Anbringen flächiger elektronischer Bauelemente, insbesondere von photovoltaischen Zellen, auf einem flexiblen Flächengebilde, die Verwendung einer programm-gesteuerten Stickmaschine, ein flexibles Flächengebilde mit mindestens einem elektronischen Bauelement und ein Solarmodul.

Sowohl im privaten wie im gewerblichen Bereich besteht ein Bedürfnis nach elektronischen Schaltungen, die flexibel angeordnet werden können. So ist es wünschenswert, dass elektronische Bauelemente, wie Sensoren, Antennen, Stromquellen und Solarzellen miniaturisiert werden und auf Kleidungstücken, Taschen, Zeltdächern, Heimtextilien usw. angebracht zum Einsatz kommen.

Es ist beispielsweise aus EP 0 379 961, US 2007/0151593 oder DE 44 36 246 bekannt, Solarmodule auf flexiblen Flächengebilden, wie Kleidungstücken, anzubringen. Die Solarzellen sind dabei bereits auf herkömmliche Weise in Modulen angeordnet und verschaltet. Dabei sind die Solarzellen in der Regel mit einer entsprechenden Verschaltung versehen und zu Modulen zusammengefasst. Sie bilden eine flächige, eher steife Einheit, die auf das damit versehen Material aufgeklebt, aufgenäht oder gestickt wird. Um eine ausreichende Menge an Strom erzeugen zu können, müssen die Solarmodule eine gewisse Grösse aufweisen und benötigen damit eine entsprechende Fläche. Die Module lassen sich dann nicht mehr an beliebigen Stellen anbringen und das textile Flächengebilde verliert seine Flexibilität. Es kann nicht mehr klein zusammengefaltet oder gerollt werden oder ist für den Träger wenig bequem.

Ausserdem ist zum Beispiel aus DE 10 2006 027 213, insbesondere für so genannte "smart textiles", aus EP 1923 680 und aus WO 2006/108310 bekannt, elektrisch leitfähige Textilstrukturen auszubilden, zum Beispiel Leiterbahnen zu nähen oder zu sticken. Mit diesen Leiterbahnen lassen sich zwar elektronische Bauelemente elektrisch leitend verbinden oder an einer Energieversorgung anschliessen. Komplexere Schaltungen, wie sie beispielsweise für die Erstellung eines Solarmoduls notwendig sind, werden aber nicht realisiert.

Aus der Druckschrift DE 103 07 505 ist eine Textilgewebestruktur mit einer Mehrzahl von Mikroelektronikkomponenten bekannt. Diese sind in der Textilgewebestruktur angeordnet, die elektrisch leitfähige Fäden umfasst. Die leitfähigen Fäden dienen zur Kopplung der Komponenten und zur Datenübertragung. Die Kopplung zwischen den leitfähigen Fäden und den Mikroelektronikmodulen kann mittels Kontaktierung durch eine flexible Leiterplatte oder mittels so genannten Drahtbondens realisiert sein.

Die Druckschrift JP 2006339683 offenbart eine Methode, um Solarzellen zu befestigen. Solarzellen werden mit einem Faden auf eine flexible Unterlage genäht. Dazu wird bevorzugt eine industrielle Nähmaschine verwendet.

Die Druckschrift JP10144947 zeigt ebenfalls das Befestigen einer Solarzelle auf einem flexiblen Untergrund mittels Nähen. Hierbei wird allerdings eine flexible Schutzschicht der Solarzelle am Untergrund befestigt.

Die Druckschrift GB2458664 zeigt das Befestigen von flexiblen photovoltaischen Mitteln auf einem flexiblen Substrat. Die photovoltaischen Mittel können mit einer Schutzschicht versehen sein, welche auf das Untergrundmaterial genäht oder gestickt werden kann.

Es besteht daher die Aufgabe, die Nachteile des Bekannten zu vermeiden und insbesondere ein flexibles Flächengebilde zu schaffen, das mit verschalteten elektronischen Bauteilen versehen ist und dabei seine Flexibilität weitgehend behält.

Die Aufgabe wird gelöst durch ein Verfahren zum Anbringen mindestens eines flächigen elektronischen Bauelements, insbesondere einer photovoltaischen Zelle, auf ein flexibles Flächengebilde mit den Merkmalen von Anspruch 1.

Das flexible Flächengebilde besteht aus bestickbarem Material, wie Textilstoff, Gewirke, Gewebe, Leder, Vlies, Folien und andere technischen Flächengebilde.

Zur elektrisch leitenden Kontaktierung des auf das flexible Flächengebilde applizierten, mindestens einen flächigen elektronischen Bauelements wird zunächst mindestens eine Leiterbahnen aufgebracht. Diese wird mit der Unterseite des mindestens einen elektronischen Bauelements elektrisch leitend kontaktiert und nachfolgend mindestens eine weitere Leiterbahn aufgebracht. Die weitere Leiterbahn kontaktiert elektrisch leitend ein zweites Oberflächensegment, insbesondere die Oberseite, des mindestens einen elektronischen Bauelements. Die Leiterbahnen können aufgeklebt oder anderweitig aufgebracht sein. Mindestens eine Leiterbahn ist aufgestickt.

Das Aufsticken erfolgt mit programm-gesteuerter Sticktechnik, insbesondere mittels einer Schiffchenstickmaschine.

Unter der Unterseite des elektronischen Bauelements wird die dem flexiblen Flächengebilde zugewandte Seite des Bauelements verstanden, unter Oberseite die von dem flexiblen Flächengebilde abgewandte Seite.

Dadurch werden die jeweils äusseren Schichten von insbesondere aus Halbleiterschichten aufgebauten Bauelementen kontaktiert, beispielsweise die p- und die n- Schicht einer photovoltaischen oder Solarzelle.

Die elektrisch leitende Kontaktierung erfolgt bevorzugt durch ein straffes Anliegen der Leiterbahn an dem elektronischen Bauelement. Dazu wird das Bauelement vorteilhafterweise auf das Flächengebilde appliziert, nachdem die erste Leiterbahn und bevor die zweite Leiterbahn gestickt wird. Beim Applizieren wird darauf geachtet, dass das Bauelement in seiner Lage gesichert ist und nicht mehr verrutschen kann.

Alternativ zu einem Anliegen der Leiterbahnen an der Unter- und/oder Oberseite kann vorgesehen sein, dass die Bauelemente mit Kontaktstellen versehen sind, von denen z.B. eine erste eine elektrisch leitende Kontaktmöglichkeit zur Unterseite, d.h. zur untersten aktiven Schicht des Bauelements, und eine weitere eine elektrisch leitenden Kontaktmöglichkeit zur Oberseite, d.h. zur obersten aktiven Schicht des Bauelements, zur Verfügung stellt. Die gestickten Leiterbahnen werden in dem Fall mit den entsprechenden Kontaktstellen in elektrisch leitende Verbindung gebracht.

Der elektrisch leitende Kontakt entsteht bevorzugt dadurch, dass die Leiterbahnen an den entsprechenden Flächen anliegen. Ein Krimpen, Klemmen, Löten oder Kleben ist nicht notwendig.

Der elektrische Kontakt kann jedoch in einem weiteren Verfahrensschritt verbessert werden. Hierzu kann beispielsweise ein leitfähiger Klebe- oder Löttropfen auf die Kontaktstelle gebracht werden.

Die Leiterbahnen verlaufen so, dass sich Leiterbahnen, welche das erste Oberflächensegment und Leiterbahnen, welche das zweite Oberflächensegment desselben Bauelements kontaktieren, gegenseitig nicht berühren.

Das Verfahren erlaubt es, einzelne elektronische Bauelemente, zum Beispiel photovoltaische Zellen, mittels Sticktechnik zu verschalten. Die einzelnen Bauelemente brauchen nicht, wie bislang üblich, schon vor dem Aufbringen auf das flexible Flächengebilde mit einer Verschaltung versehen und zu Modulen zusammen gefasst werden.

Die Verfahrensschritte (i) Leiterbahn sticken, (ii) elektrisch leitenden Kontakt zum ersten Oberflächensegment, z.B. zur Unterseite, des Bauelements schaffen und (iii) weitere Leiterbahn sticken, die elektrisch leitenden Kontakt zum zweiten Oberflächensegment, z.B. zur Oberseite, des Bauelements haben, können vollständig oder teilweise wiederholt ausgeführt werden, wobei zum Beispiel eine Leiterbahn die Unterseite eines Bauelements mit der Oberseite eines weiteren Bauelements elektrisch leitend verbindet, sodass die Bauelemente in Reihe geschaltet sind.

Alternativ oder zusätzlich können jeweils die ersten Oberflachensegmente und die zweiten Oberflächensegmente, also z. B. Unterseiten und Oberseiten, von einzelnen Bauelementen oder von Serien von Bauelementen miteinander elektrisch leitend verbunden werden, wodurch die Bauelemente oder Serien von Bauelementen parallel geschaltet sind.

Die Bauelemente können auf das flexible Flächengebilde geklebt, geschraubt, genietet oder anderweitig befestigt werden. In einer bevorzugten Ausführungsform wird das mindestens eine elektronische Bauelement mit programm-gesteuerter Sticktechnik, insbesondere mittels einer Schiffchenstickmaschine, einer Mehrkopfstickmaschine oder einer anderen Stickmaschine, aufgebracht und befestigt.

Das Aufbringen und Befestigen des mindestens einen elektronischen Bauelements erfolgt dabei in einem Verfahren, wie es auch z.B. für das Aufbringen von Pailletten o.ä. verwendet wird. Die Bauelemente befinden sich dafür auf einem Band, das von einer Spule abgerollt und der Nadel zum Aufsticken zugeführt wird. Die Bauelemente können entweder mindestens eine Öffnung zum Durchführen der Nadel aufweisen, können von der Sticknadel durchstochen werden oder können ohne Durchstechen überstickt werden.

Der gesamte Prozess des Anbringens und Kontaktierens kann somit mit programm-gesteuerter Sticktechnik erfolgen.

Das Aufsticken der Leiterbahnen und/oder das Befestigen des mindestens einen Bauelements erfolgt vorteilhafterweise im Zweifadensystem, mit Ober- und Unterfaden.

Die Ober- und/oder Unterfäden zum Sticken der Leiterbahnen sind elektrisch leitend. Dazu bestehen sie aus elektrisch leitendem Material oder enthalten zumindest elektrisch leitendes Material. Das Garn enthält zum Beispiel Metallfäden. Ein Faden kann beispielsweise aus einem kupfer- oder silberumsponnenen Kern aus PE bestehen. Das Garn kann aus einem beschichteten Material bestehen, wobei jeweils nur der Kern oder die Beschichtung leitfähig sein können.

Die Leiterbahn kann entweder selbst mindestens einer der Stickfäden sein, z.B. in einem Zweifadensystem, oder mittels weiterer Stickfäden befestigt werden, z.B. in einem Dreifadensystem.

Im zuletzt genannten Fall muss das Material für die Leiterbahn weder durch das flexible Gebilde hindurch geführt werden noch mittels einer Nadel appliziert werden. Es bestehen daher keine besonderen Anforderungen an die Biegbarkeit des Leiters, welche unter Umständen mit der Leitfähigkeit konkurrieren kann. Als Leiterbahn kann beispielsweise ein leitfähiger Faden oder ein Metallband verwendet werden. Die Stickfäden können ebenfalls leitfähig sein.

Das mindestens eine elektronische Bauteil kann entweder direkt beim Aufsticken der Leiterbahnen mit befestigt werden, wobei der oder die Fäden für die Leiterbahn zum Kontaktieren des ersten oberflächensegments, z.B. der Unterseite, und/oder der oder die Fäden für die Leiterbahn zum Kontaktieren des zweiten Oberflächensegments, z.B. der Oberseite, zum Feststicken des Bauteils verwendet werden.

In einer vorteilhaften Ausführung der Erfindung wird das mindestens eine Bauelement in einem separaten Verfahrensschritt mittels nicht leitender Fäden aufgestickt. Das separate Befestigen der Bauelemente erlaubt die Verwendung von dünnen, reissfesten Fäden und einem Stickverlauf, der zu einer soliden mechanischen Verbindung führt, und bei welcher der elektrischen Kontaktierung keine Rechung getragen werden muss. Wenn die Bauelemente gut an dem flexiblen Flächengebilde anliegen, ergibt sich für das fertige Produkt eine geringe Anfälligkeit gegenüber Beschädigungen, die durch Abreissen oder Abknicken von Bauelementen entstehen könnten. Das Produkt wird dadurch robuster, es kann vielfältiger und länger eingesetzt werden.

Gleichzeitig werden die Bauelemente so an dem flexiblen Flächenelement befestigt, dass auch bei einer Faltung des flexiblen Flächenelements stets ein guter elektrisch leitender Kontakt zu den Leiterbahnen gewährleistet ist.

Der Stickverlauf ist so gewählt, dass ein Bauteil zum einen solide mit dem Untergrund und den Leiterbahnen verbunden ist, zum anderen die Oberseite des Bauteils nicht unnötig bedeckt ist. Insbesondere wird die photoaktive Fläche einer Solarzelle nicht unnötig beeinträchtigt. Dazu können auch lichttransparente Fäden verwendet werden.

In modernen Stickmaschinen können gleichzeitig mehrere Leiterbahnen und/oder elektronische Bauteile aufgestickt werden. Flexible Flächenelemente können in jeglichen Breiten, bis zum Beispiel 180 cm, und in praktisch jedem Rapport gefertigt werden. Der Stickverlauf erlaubt beliebige Anordnungen und Verschaltungen der Bauelemente. Es sind somit Schaltungen in massgeschneiderter Form und Grösse herstellbar.

Vorteilhafterweise werden die elektronischen Bauelemente in einem regelmässigen Muster, vorzugsweise etwa aneinander anliegend, auf das Flächengebilde appliziert. Dabei wird die Fläche, welche das Flächengebilde bietet, optimal ausgenutzt. Handelt es sich bei den Bauelementen um photovoltaische Zellen, so wird der Wirkungsgrad bezogen auf die zur Verfügung stehende Fläche optimiert.

Das fertige Produkt zeichnet sich durch eine mehrheitlich bedeckte, aber flexible Oberfläche aus.

Vorteilhafterweise wird das elektronische Bauelement in einem weiteren Verfahrensschritt zumindest teilweise mit einer bevorzugt lichtdurchlässigen Schutzschicht überzogen.

Die Schutzschicht sorgt für einen verbesserten mechanischen Halt, verhindert ein Abstehen der Bauelemente vom Untergrund und schützt die Bauelemente und Leiterbahnen vor äusseren Einflüssen, wie Staub und Feuchtigkeit, und mechanischer Beanspruchung, wie Schlägen und Kratzern.

Gleichzeitig bewahrt die Schutzschicht die Funktionsfähigkeit der elektrisch leitenden Kontakte und verhindert die Unterbrechung, die Überbrückung oder sonstige Beeinträchtigung der gestickten elektrisch leitenden Verbindungen.

Die Schutzschicht kann als abschliessender Schritt auf das flexible Flächengebilde, das darauf befindliche mindestens eine elektronische Bauelement und die Leiterbahnen aufgebracht werden. Die Schutzschicht kann aber auch vor dem Applizieren des Bauelements auf das Flächengebilde auf das Bauelement aufgebracht werden. In diesem Fall muss die Schicht vor dem Kontaktieren, beispielsweise mit einem Laser, zumindest teilweise entfernt und bevorzugt nach dem Kontaktieren wieder geschlossen werden.

Die Schutzschicht kann zum Beispiel als Folie aufgewalzt, als aushärtende Flüssigkeit aufgesprüht, als Pulver aufgebracht oder thermisch fixiert sein.

Als weiterer Verfahrensschritt kann vorgesehene sein, das flexible Flächengebilde zusammen mit den aufgebrachten Bauelementen erwärmt werden, z.B. in einem Ofen oder in einem Laufrahmen. Dabei kann ein Sintern der elektronischen Bauelemente erfolgen. Das Material und/oder die Kontakte verfestigen sich dabei. Die Schutzschicht wird nachfolgend aufgebracht.

Die der Erfindung zugrunde liegende Aufgabe wird weiterhin gelöst durch die Verwendung einer Stickmaschine zum Aufsticken von mindestens einer Leiterbahn und zum Aufbringen, Befestigen und Kontaktieren von mindestens einem elektronischen Bauelement, insbesondere einer photovoltaischen Zelle, auf ein flexibles Flächengebilde, wobei eine erste Leiterbahn nur ein erstes Oberflächensegment, insbesondere die Unterseite, von mindestens einem Bauelement und eine zweite Leiterbahn nur ein zweites Oberflächensegment, insbesondere die Oberseite, von demselben mindestens einen Bauelement kontaktiert.

Moderne Stickmaschinen erlauben das Gestalten komplexer Stickwege und das Zuführen und Befestigen von flächigen Elementen. Die Fadenzuleitungen, die Sticknadeln und die Einrichtung zur Zufuhr der flächigen Elemente sind so auszubilden, dass leitendes Garn und elektronische Bauelemente verarbeitet werden können.

Die Aufgabe wird ausserdem gelöst durch ein flexibles Flächengebilde mit mindestens einem elektronischen Bauelement, insbesondere einer photovoltaischen Zelle oder einem Solarmodul, und mindestens einer, insbesondere im Zweifadensystem, gestickten elektrischen Leiterbahn, gemäss den Merkmalen des Anspruchs 10.

Erfindungsgemäss kontaktiert eine erste Leiterbahn nur ein erstes Oberflächensegment, insbesondere die Unterseite, von mindestens einem Bauelement und eine zweite Leiterbahn nur ein zweites Oberflächensegment, insbesondere die Oberseite, von demselben mindestens einen Bauelement.

Die Leiterbahnen und/oder das mindestens eine Bauelement sind dabei bevorzugt in einem Verfahren wie oben beschrieben angebracht worden.

Sind mehrere elektronische Bauelemente vorgesehen, so können deren erste und zweite Oberflächensegmente, z.B. Unterseiten und Oberseiten, von je einer gemeinsamen Leiterbahn verbunden sein, wodurch eine Parallelschaltung entsteht. Oder eine Leiterbahn verbindet die Unterseite eines Bauelements mit der Oberseite eines weiteren Bauelements, wodurch eine Serienschaltung entsteht.

Kombinationen von Serien- und Parallelschaltungen können ebenfalls realisiert werden.

Die Flächen können so ausgebildet sein, dass sie einen guten Kontakt zu den leitfähigen Fäden ermöglichen. Zum Beispiel können an der Unterseite und/oder an der Oberseite Rillen vorgesehen sein, in welchen die Fäden verlaufen. Die elektronischen Bauteile können dazu beispielsweise mit einem Laser bearbeitet sein.

Der elektrisch leitende Kontakt kann auch über entsprechende Kontaktstellen, die an auf dem elektronischen Bauteil vorgesehen sind, hergestellt werden. Die Kontaktstellen können bereits auf dem Substrat des elektronischen Bauteils ausbildet sein.

Das elektronische Bauteil kann an dem Flächengebilde aufgeklebt, angenietet, angeschraubt oder anderweitig befestigt sein. In einer vorteilhaften Ausführung der Erfindung ist das mindestens eine Bauelement auf dem Flächengebilde, insbesondere im Zweifadensystem, festgestickt. Zum Feststicken kann ein Faden verwendet sein, der gleichzeitig eine elektrisch leitende Kontaktierung herstellt und zu einer Leiterbahn gehört. Alternativ kann ein nicht leitender Faden benutzt sein.

Ein nicht leitender Faden kann durch das Bauelements geführt werden, ohne die elektronischen Eigenschaften des Bauelements zu beinträchtigen, zum Beispiel ohne eine leitende Verbindung zwischen Unter- und Oberseite des Bauteils herzustellen.

Vorteilhafterweise ist eine Schutzschicht vorgesehen, welche zumindest ein zweites Oberflächensegment, insbesondere die Oberseite, des mindestens einen Bauelements abdeckt. Die Schutzschicht kann grossflächig auf dem flexiblen Flächengebilde angebracht sein, sodass Bauelemente und Leiterbahnen wirksam vor äusseren Einflüssen geschützt werden. Die Schutzschicht ist bevorzugt lichtdurchlässig.

In einer vorteilhaften Ausführung der Erfindung ist eine Vielzahl von miteinander elektrisch leitend in Reihe und/oder Serie verbundenen Bauelementen vorgesehen, die insbesondere zusammen mindestens ein Solarmodul bilden. Bei den Bauelementen handelt es in diesem Fall vorwiegend um Solarzellen. Auch andere Bauelemente zur Verschaltung von Solarzellen, zum Beispiel Bypassdioden, können in die Schaltung integriert sein.

Das Bauelement hat bevorzugt einen grössten Oberflächendurchmesser zwischen 3 mm und 30 mm, insbesondere grösser als 10 mm und bis zu 25 mm oder insbesondere von etwa 6 mm.

Bei dem Bauelement kann es sich um ein, bevorzugt miniaturisiertes, Solarmodul mit mindestens einer Solarzelle handeln.

Das Solarmodul kann teilweise oder vollständig verkapselt sein und eine interne Verschaltung aufweisen. Die elektrischen Anschlüsse sind so angebracht, dass eine Verbindung zu einer auf dem flexiblen Substrat befindlichen oder anzubringenden Leiterbahn hergestellt werden kann.

Die mindestens eine Solarzelle oder ein Solarmodul ist bevorzugt auf einer Plattform angeordnet. Die Plattform kann mit Leiterbahnen zum Anbinden und/oder Verschalten von Solarzellen und/oder Solarmodulen versehen sein.

Bei der Plattform kann es sich um ein Substrat handeln, auf welches das photovoltaisch aktive Material aufgebracht wird, beispielsweise mittels Dünnschichtverfahren. Es können auch Solarmodule auf der Basis von amorphem oder kristallinem Silizium vorgesehen sein.

Die Plattform kann ein elektrisch isolierendes Hilfssubstrat sein, das die Ausmasse der eigentlichen Solarzelle oder des Solarmoduls gar nicht oder nicht westlich überschreitet.

Die Plattform kann aus flexiblem Material bestehen.

Die Plattform kann bereits derart vorbereitet sein, dass Möglichkeiten für die Befestigung des Bauelements auf dem flexiblen Gebilde und/oder Möglichkeiten zur elektrischen Kontaktierung an Leiterbahnen angeboten werden. Dazu kann die Plattform beispielsweise Löcher aufweisen, an denen eine Befestigung und/oder Kontaktierung mittels eine Fadens möglich ist.

Die Plattform kann auch leitfähige Bereiche aufweisen, beispielsweise am Rand der Plattform, die nicht von der Solarzelle oder dem Solarmodul abgedeckt sind. Die Plattform kann mit Kontaktfahnen versehen sein, die flexibel sein können, beispielsweise aus Stoff oder Folie bestehen, und über die eine elektrische Kontaktierung mit einer Leiterbahn hergestellt werden kann.

Die Plattform mit den darauf befindlichen Solarzellen und Leiterbahnen kann teilweise oder vollständig umkapselt sein. Ein Umkapselungsmaterial schützt das Bauelement vor Umwelteinflüssen. Es ist bevorzugt isolierend und lichtdurchlässig.

Es kann vorgesehen sein, dass nur gewisse Bereiche, beispielsweise dort, wo eine Solarzelle bzw. ein Solarmodul vorgesehen ist, mit Umkapselungsmaterial bedeckt sind. Es kann auch die gesamte Oberseite der Plattform, auf welcher Solarzellen, Solarmodule und/oder Leiterbahnen angebracht sind verkapselt sein. Oder die gesamte Plattform ist umkapselt.

Es können Bereiche von der Umkapselung ausgenommen sein, die für eine elektrische Kontaktierung, z.B. mittels Sticken, Nähen, Kleben oder Löten vorgesehen sind.

Ein miniaturisiertes Solarmodul kann hergestellt werden, indem auf eine Plattform Leiterbahnen und Solarzellen aufgebracht werden und diese zumindest teilweise umkapselt werden.

Die Aufgabe wird ausserdem gelöst durch ein Solarmodul bestehend aus einer Vielzahl miteinander elektrisch leitend verbundener Solarzellen oder Solarmodule, wobei die Solarzellen jeweils auf ein flexibles Flächengebilde gestickt sind. Das Anbringen und elektrisch leitende Kontaktieren der Solarzellen erfolgt insbesondere in einem Verfahren wie oben beschrieben.

Die individuelle Befestigung der Solarzellen am Trägermaterial mittels Sticktechnik erlaubt eine flexible Wahl von Anordnungen der einzelnen Zellen und Abmessungen des Moduls.

Handelt es sich bei dem Trägermaterial um ein flexibles Flächengebilde, so kann das Solarmodul gefaltet und aufgerollt werden. Das Solarmodul ist dann vielfältig einsetzbar und leicht transportabel.

Die Erfindung ist im Folgenden in Ausführungsbeispielen anhand von Zeichnungen erläutert.
- Figur 1: zeigt schematisch eine Draufsicht auf ein erstes Beispiel für ein flexibles Flächengebilde mit in Serie geschalteten Bauelementen;
- Figur 2: zeigt schematisch eine Draufsicht auf ein zweites Beispiel für ein flexibles Flächengebilde mit parallel geschalteten Bauelementen;
- Figur 3: zeigt schematisch ein Schnittbild von Figur 2 entlang der Linie I-I;
- Figur 4: zeigt schematisch die Schnittansicht eines dritten Beispiels für ein flexibles Flächengebilde mit beschichteten Bauelementen;
- Figur 5: zeigt schematisch die Schnittansicht eines vierten Beispiels für ein flexibles Flächengebilde mit beschichteten Bauelementen;
- Figur 6: zeigt schematisch eine Draufsicht auf ein fünftes Beispiel für ein flexibles Flächengebilde mit in Serie geschalteten Bauelementen;
- Figur 7: zeigt schematisch ein Schnittbild von Figur 6 entlang der Linie II-II;
- Figuren 8a-8g: zeigen schematisch verschiedene Möglichkeiten zur Befestigung von Solarmodulen an flexiblen Flächengebilden.

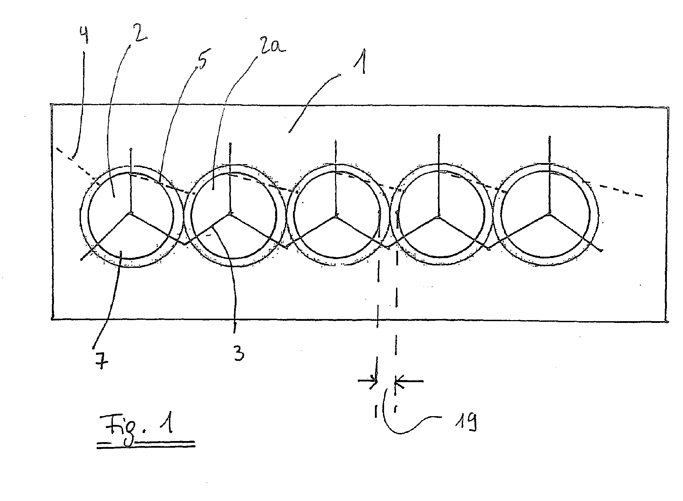

Figur 1 zeigt schematisch ein flexibles Flächengebilde 1, das mit elektronischen Bauelementen 2 bestückt ist. In dem gezeigten Beispiel sind die Bauelemente 2 mit einem nicht leitenden Faden 3 an dem flexiblen Flächengebilde 1 festgestickt. Zu jedem Bauelement 2 ist eine Leiterbahn 4 vorgesehen, welche die in der Zeichnung nicht näher gezeigte Unterseite des Bauelements 2 elektrisch leitend kontaktiert, und eine weitere Leiterbahn 5, welche die Oberseite 7 des Bauelements 2 elektrisch leitend kontaktiert.

Das Stickmuster ist so gewählt, dass die Leiterbahn die Oberseite 7 eines Bauelements 2 mit der (nicht gezeigten) Unterseite eines benachbarten Bauelements 2a verbindet.

Die Bauelemente 2 sind in einem Abstand 19 angeordnet.

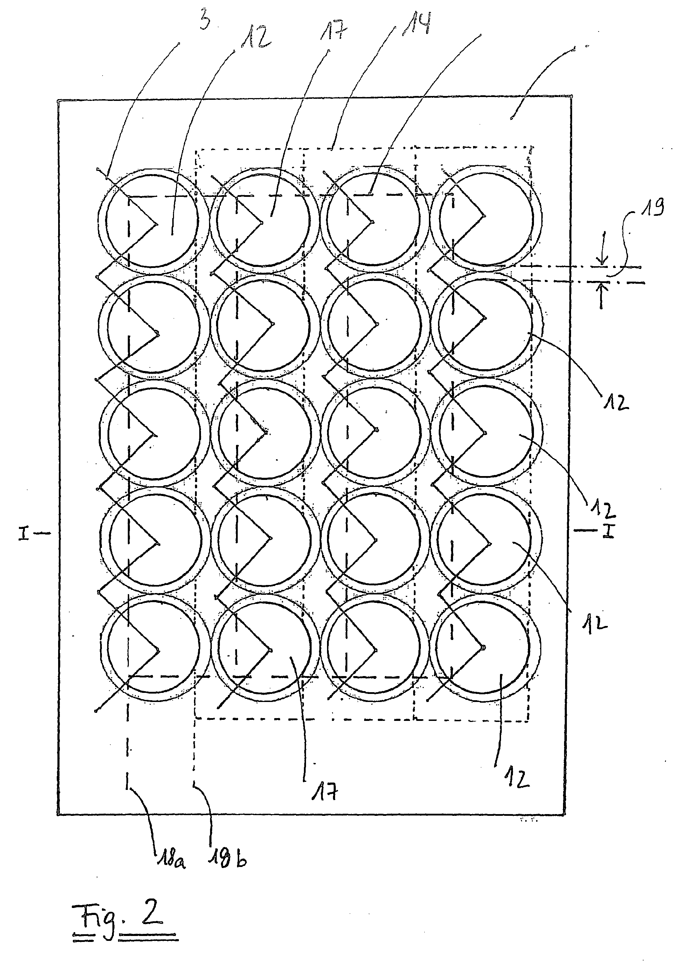

Figur 2 zeigte ebenfalls schematisch ein flexibles Flächengebilde 11, das mit elektronischen Bauelementen 12 bestückt ist. Die elektronischen Bauelemente 12 sind auch in diesem Beispiel mit einem nicht leitenden Faden 13 festgestickt. Eine erste Leiterbahn 14 verbindet alle in der Figur nicht gezeigten Unterseiten der Bauelemente 12, eine weitere Leiterbahn 15 verbindet die Oberseiten 17 der Bauelemente 12. Auf diese Weise sind die Bauelement 12 in einer Parallelschaltung angeordnet.

Die Enden 18a, 18b der Leiternbahnen 13, 14 können so ausgeführt sein, dass sie von aussen aus abgegriffen werden können, zum Beispiel über eine in der Figur nicht gezeigte Klemme oder einen Stecker.

Die gesamte Anordnung ist mit einer in dieser Figur nicht dargestellten Schutzschicht 20 überzogen.

Alternativ können auch Serien von Bauelementen, wie z.B. in Figur 1 gezeigt, parallel geschaltet werden.

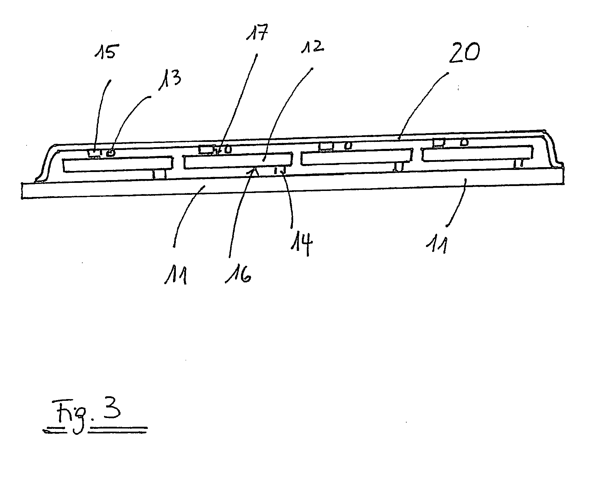

Figur 3 zeigt schematisch ein Schnittbild von Figur 2 entlang einer Schnittlinie I-I. Die dem flexiblen Flächengebilde 11 zugewandten Unterseiten 16 der elektronischen Bauelemente 12 werden von einer ersten Leiterbahn 14 kontaktiert und die dem flexiblen Flächengebilde 11 abgewandten Oberseiten 17 der elektronischen Bauelemente 12 von einer zweiten Leiterbahn 15. Die elektronischen Bauelemente 12 werden mit einem nicht leitenden Faden 13 an das flexible Flächengebilde befestigt.

Die gesamte Anordnung ist mit einer Schutzschicht 20 überzogen. Bei den elektronischen Bauelementen 12 handelt es sich bevorzugt um photovoltaischen Zellen auf der Basis von CIS, CIGS, CIGSS, CdTe, CdS, TiO2, a- Si:H, SiGE, GaAs, GaInP, GaInAs oder anderen Halbleitern oder Halbleiterverbindungen. Bevorzugt haben sie einen grössten Oberflächendurchmesser zwischen 3mm und 10mm, weiter bevorzugt von etwa 6mm.

Die leitenden Fäden 13 bestehen aus leitendem, teilweise leitendem oder nicht leitendem Material und können mit leitendem Material beschichtet oder umsponnen sein.

Als flexibles Flächengebilde 11 kann jedes Material verwendet werden, das mit einer Sticknadel durchstechbar ist.

Die Schutzschicht 20 besteht beispielsweise aus einem Polymer, aus einem Glas oder aus Teflon.

Eine dünne Schutzschicht 20 aus einem Polyester oder einem Polyamid kann z.B. in einem Foulard aufgebracht werden. Die gesamte Anordnung bleibt auch mit Schutzschicht 20 flexibel.

Das Sticken erfolgt mit einem Steppstich, einem Tourenstich, einem Plattstich, einem Geflecht oder einer anderen Stickart.

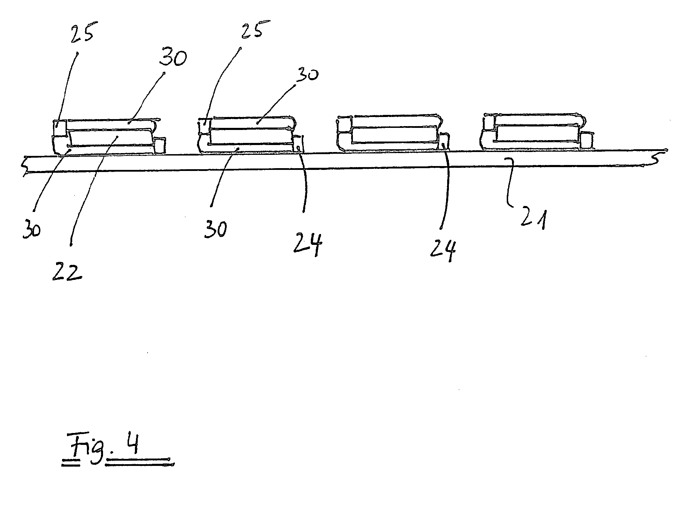

Figur 4 zeigt schematisch die Schnittansicht eines dritten Beispiels für ein flexibles Flächengebilde 21 mit beschichteten Bauelementen 22. Die Bauelemente 22 jeweils wurden vor dem Aufbringen komplett mit einer Schutzschicht 30 überzogen und somit verkapselt. Die Schutzschicht 30 muss zum Kontaktieren an mindestens zwei Kontaktstellen, an welchen die erste Leiterbahn 24 und die zweite Leiterbahn 24 anliegen entfernt werden. Die Schutzschicht 30 kann dazu, bevorzugt noch vor dem Aufbringen, beispielsweise abgeätzt oder mit einem Laser entfernt werden.

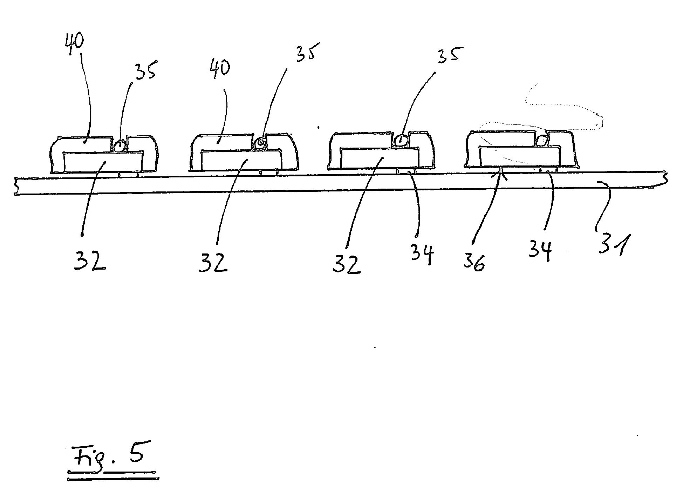

Figur 5 zeigt schematisch die Schnittansicht eines dritten Beispiels für ein flexibles Flächengebilde 31 mit beschichteten Bauelementen 32. Die Bauelemente 32 sind bereits vor dem Applizieren auf einer Unterlage angeordnet, zum Beispiel auf einer Kleberolle. Auf dieser können die Bauelemente 32 mit einer Schutzschicht 40 beschichtet werden, sodass die Unterseite 36 der Bauelemente 32 unbeschichtet bleibt und direkt mit einer ersten Leiterbahn 34 kontaktiert werden kann. Vor dem Kontaktieren mit der zweiten Leiterbahn 35 muss die Schutzschicht 40 an der Kontaktstelle entfernt werden. Dies kann, zum Beispiel mit einem Laser, geschehen, wenn die Bauelemente 32 bereits auf dem textilen Flächengebilde 32 aufgebracht sind.

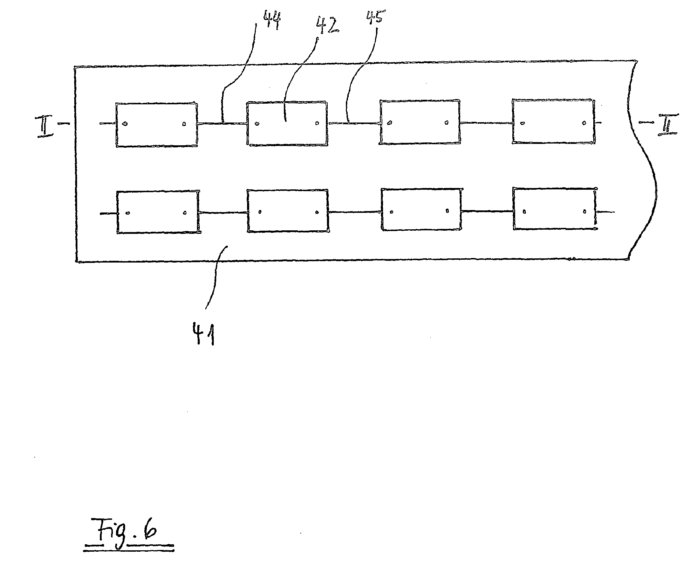

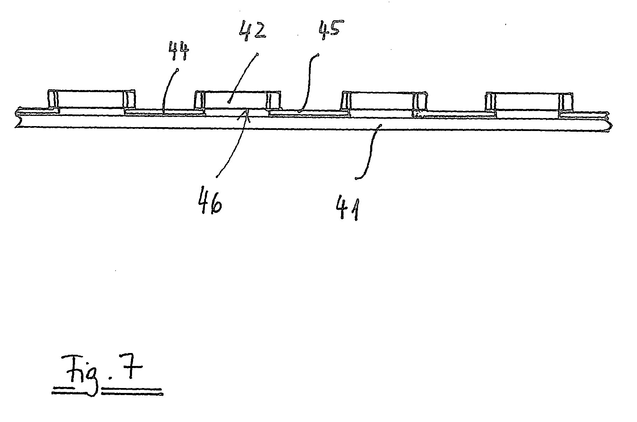

Figur 6 zeigt schematisch eine Draufsicht auf ein fünftes Beispiel für ein flexibles Flächengebilde 41 mit in Serie geschalteten Bauelementen 42. Figur 7 zeigt schematisch ein Schnittbild von Figur 6 entlang der Linie II-II.

Die Bauelemente 42 in diesem Beispiel sind so ausgeführt, dass sich die Kontaktstellen an der Unterseite 46 der Bauelemente 42 befinden.

Eine erste Leiterbahn 44 kontaktiert das Bauelement 42 an einem ersten Oberflächensegment, das sich an der Unterseite 46 des Bauelements 42 befindet. Eine zweite Leiterbahn 45 kontaktiert ein zweites Oberflächensegment desselben Bauelements 42, das sich ebenfalls an der Unterseite 46 des Bauelements 42 befindet.

Die elektrische Kontaktierung erfolgt mittels leitender Sticktechnikverbindung. Die Bauelemente 42 können zusätzlich mit, in der Figur nicht explizit gezeigten, nicht leitenden Sicherungsfäden überstickt sein.

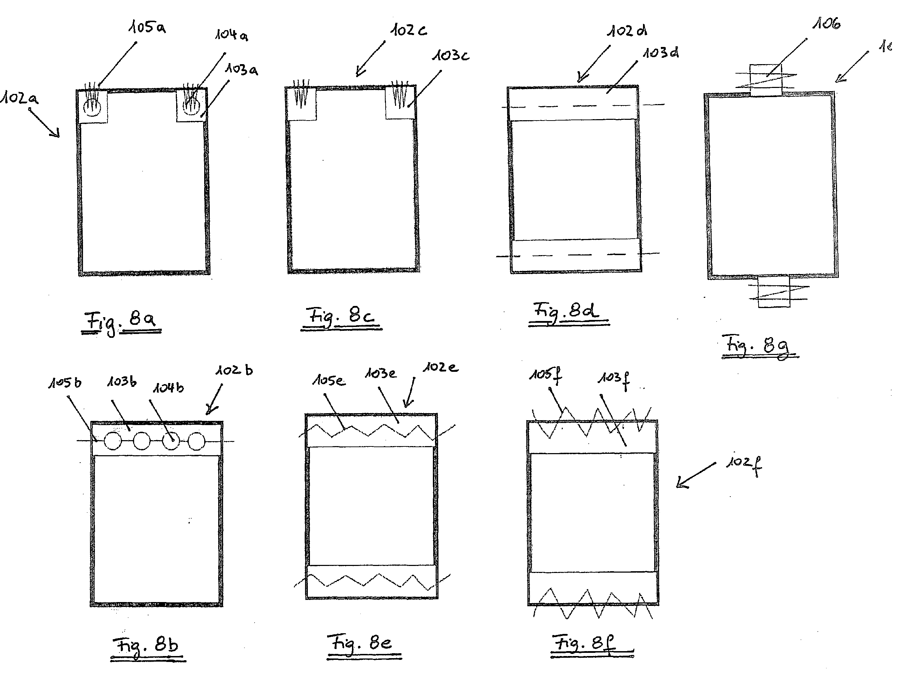

Figuren 8a-8g zeigen schematisch verschiedene Möglichkeiten zur Befestigung von Solarmodulen 102a, 102b, 102c, 102d, 102e, 102f, 102g an flexiblen Flächengebilden 101.

In Figur 8a und 8b weisen die Solarmodule 102a und 102b einseitig vorgesehene Kontaktbereiche 103a, 103b mit Löchern 104a, 104b auf. Diese können für eine Stickverbindung, beispielsweise mittels eines leitfähigen Fadens 105a, 105b, benutzt werden.

Die in Figuren 8c, 8d, 8e und 8f gezeigten Solarmodule 102c, 102d, 102e und 102f besitzen ebenfalls Kontaktbereiche 103c, 103d, 103e und 103f, allerdings ohne Löcher. Die Kontaktbereiche 103c, 103d, 103e und 103f müssen für eine Fixierung mit einem Faden durchstochen werden.

Die in den Figuren 8a-8c gezeigten Kontaktbereiche 103a, 103b, 103c sind an einer Kante des Solarmoduls 102a, 102b, 102c angeordnet. Erfolgt die Fixierung ausschliesslich über die Kontaktbereiche 103a, 103b, 103c, so sind die fixierten Solarmodule 102a, 102b, 102c schuppenartig auf dem flexiblen Flächengebilde angebracht. Es besteht in diesem Fall keine flächige Verbindung zwischen den Solarmodulen 102a, 102b, 102c und dem flexiblen Flächengebilde, was zur besseren Drappierbarkeit der mit Solarmodulen versehenen flexiblen Flächengebilde beiträgt.

Ein leitfähiger Stickfaden 105e, 105f kann, wie z.B. in Figuren 8e und 8f gezeigt ist, zickzackartig hin- und hergeführt werden, um eine grössere Kontaktfläche zu erreichen.

Das in Figuren 8g gezeigte Solarmodul 101g weist zwei Kontaktfahnen 106 auf, die aus leitfähigem Stoff oder leitfähiger Folie gefertigt sind.

## Patentansprüche

1. Verfahren zum Anbringen mindestens eines flächigen elektronischen Bauelements, insbesondere einer photovoltaischen Zelle oder eines Solarmoduls, auf ein flexibles Flächengebilde, **dadurch gekennzeichnet, dass** zur elektrisch leitenden Kontaktierung des auf das flexible Flächengebilde applizierten flächigen elektronischen Bauelements
(i) zunächst mindestens eine erste Leiterbahn (4; 14; 24; 34; 44) aufgebracht,
(ii) diese mit einem ersten Oberflächensegment, insbesondere der Unterseite (16; 36; 46), des elektronischen Bauelements (2, 2a; 12; 22; 32; 42) elektrisch leitend kontaktiert wird und
(iii) nachfolgend mindestens eine zweite Leiterbahn (5; 15; 25; 35; 45) aufgebracht wird, welche ein zweites Oberflächensegment, insbesondere die Oberseite (7; 17), desselben elektronischen Bauelements (2, 2a; 12; 22; 32; 42) elektrisch leitend kontaktiert,
wobei mindestens eine Leiterbahn (4, 5; 14, 15; 24, 25; 34, 35; 44, 45)aufgestickt wird, insbesondere mit programm-gesteuerter Sticktechnik, insbesondere mittels einer Schiffchenstickmaschine.

2. Verfahren nach Anspruch 1, **dadurch gekennzeichnet, dass** das elektronische Bauelement (2, 2a; 12; 22; 32; 42) mit programm-gesteuerter Sticktechnik, insbesondere mittels einer Schiffchenstickmaschine, aufgebracht und befestigt wird.

3. Verfahren nach Anspruch 1 oder 2, **dadurch gekennzeichnet, dass** in einem separaten Verfahrensschritt das Bauelement (2, 2a; 12; 22; 32; 42) mittels nicht leitender Fäden (3; 13) aufgestickt wird.

4. Verfahren nach Anspruch 1, **dadurch gekennzeichnet, dass** in einem separaten Verfahrensschritt das Bauelement (2, 2a; 12; 22; 32; 42) aufgeklebt wird.

5. Verfahren nach mindestens einem der vorhergehenden Ansprüche, **dadurch gekennzeichnet, dass** in einem weiteren Verfahrensschritt das elektronische Bauelement (2, 2a; 12; 22; 32; 42) zumindest teilweise mit einer bevorzugt lichtdurchlässigen Schutzschicht (20; 30; 40) überzogen wird.

6. Verfahren nach Anspruch 5, **dadurch gekennzeichnet, dass** die Schutzschicht (20; 30; 40) auf das elektronische Bauelement (2, 2a; 12; 22; 32; 42) aufgebracht wird und vor dem elektrischen Kontaktieren zumindest teilweise wieder entfernt wird.

7. Verfahren nach Anspruch 5, **dadurch gekennzeichnet, dass** die Schutzschicht (20; 30; 40) als Folie auf das Flächengebilde (1; 11; 21; 31; 41) und das darauf aufgebrachte elektronische Bauelement (2, 2a; 12; 22; 32; 42) aufgebracht wird, insbesondere aufgewalzt wird oder als aushärtende Flüssigkeit aufgesprüht wird.

8. Verfahren nach mindestens einem der vorhergehenden Ansprüche, **dadurch gekennzeichnet, dass** die elektronischen Bauelemente (2, 2a; 12; 22; 32; 42) in einem regelmässigen Muster, vorzugsweise mit einem Abstand nebeneinander, auf das Flächengebilde (1; 11; 21; 31; 41) appliziert werden.

9. Verwendung einer Stickmaschine, insbesondere einer Schiffchenstickmaschine, zum Aufsticken von mindestens einer Leiterbahn und zum Aufbringen, Befestigen und Kontaktieren von mindestens einem elektronischen Bauelement (2, 2a; 12; 22; 32; 42), insbesondere einer photovoltaischen Zelle oder einem Solarmodul, auf ein flexibles Flächengebilde (1; 11; 21; 31; 41), wobei wenigstens eine erste Leiterbahn nur ein erstes Oberflächensegment, insbesondere die Unterseite, von dem Bauelement (2, 2a; 12; 22; 32; 42) und wenigstens eine zweite Leiterbahn nur ein zweites Oberflächensegment, insbesondere die Oberseite, desselben Bauelements (2, 2a; 12; 22; 32; 42) kontaktiert.

10. Flexibles Flächengebilde mit mindestens einem elektronischen Bauelement, insbesondere einer photovoltaischen Zelle oder einem Solarmodul, und mindestens einer, insbesondere im Zweifadensystem, gestickten elektrischen Leiterbahn, **dadurch gekennzeichnet, dass** eine erste Leiterbahn (4; 14; 24; 34; 44) nur ein erstes Oberflächensegment, insbesondere die Unterseite, von dem Bauelement (2, 2a; 12; 22; 32) und eine zweite Leiterbahn (5; 15; 25; 35; 45) nur ein zweites Oberflächensegment, insbesondere die Oberseite (7; 17), desselben Bauelements (2, 2a; 12; 22; 32; 42) kontaktiert.

11. Flexibles Flächengebilde nach Anspruch 10, **dadurch gekennzeichnet, dass** das mindestens eine Bauelement (2, 2a; 12; 22; 32; 42) auf dem Flächengebilde (1; 11; 21; 31; 41), insbesondere im Zweifadensystem, festgestickt ist.

12. Flexibles Flächengebilde nach Anspruch 10 oder 11, **dadurch gekennzeichnet, dass** eine Schutzschicht (20; 30; 40) vorgesehen ist, welche zumindest das zweites Oberflächensegment, insbesondere die Oberseite, des mindestens einen Bauelements (2, 2a; 12; 22; 32; 42) abdeckt.

13. Flexibles Flächengebilde nach mindestens einem der Ansprüche 10 bis 12, **dadurch gekennzeichnet, dass** eine Vielzahl von miteinander elektrisch leitend in Reihe und/oder Serie verbundenen Bauelementen (2, 2a; 12; 22; 32 ;42) vorgesehen ist, die insbesondere zusammen mindestens ein Solarmodul bilden.

14. Flexibles Flächengebilde nach mindestens einem der Ansprüche 10 bis 13, **dadurch gekennzeichnet, dass** die Leiterbahnen (4, 5; 14, 15; 24, 25; 34, 35; 44, 45) Silber oder Kupferfäden enthalten.

15. Flexibles Flächengebilde nach mindestens einem der Ansprüche 11 bis 12, **dadurch gekennzeichnet, dass** das mindestens eine Bauelement (2, 2a; 12; 22; 32; 42) mittels nicht leitender Fäden überstickt und/oder aufgestickt ist.

16. Flexibles Flächengebilde nach mindestens einem der Ansprüche 10 oder 12 bis 14, **dadurch gekennzeichnet, dass** das mindestens eine Bauelement (2, 2a; 12; 22; 32; 42) aufgeklebt ist.

17. Flexibles Flächengebilde nach mindestens einem der Ansprüche 10 bis 16, **dadurch gekennzeichnet, dass** das mindestens eine Bauelement (2, 2a; 12; 22; 32; 42) einen grössten Oberflächendurchmesser zwischen 3 mm und 30 mm hat, insbesondere grösser als 10 mm und bis zu 25 mm oder insbesondere von etwa 6 mm hat.

## Claims

1. Method for attaching at least one flat electronic component, in particular a photovoltaic cell or a solar module, onto a flexible surface structure, **characterized in that**, to establish electrically conducting contact for the flat electronic component applied to the flexible surface structure,
(i) firstly at least one first conductive track (4; 14; 24; 34; 44) is applied,
(ii) an electrically conducting contact of this conductive track with the first surface segment, in particular the underside (16; 36; 46) of the electronic component (2, 2a; 12; 22; 32; 42), is established,
(iii) and then at least one second conductive track (5; 15; 25; 35; 45) is applied and establishes electrically conducting contact with a second surface segment, in particular the upper side (7; 17), of the same electronic component (2, 2a; 12; 22; 32; 42),
at least one conductive track (4, 5; 14, 15; 24, 25; 34, 35; 44, 45) being embroidered on, in particular by a program-controlled embroidering technique, in particular by means of a shuttle embroidering machine.

2. Method according to Claim 1, **characterized in that** the electronic component (2, 2a; 12; 22; 32; 42) is applied and fastened by a program-controlled embroidering technique, in particular by means of a shuttle embroidering machine.

3. Method according to Claim 1 or 2, **characterized in that**, in a separate method step, the component (2, 2a; 12; 22; 32; 42) is embroidered on by means of nonconducting threads (3; 13).

4. Method according to Claim 1, **characterized in that**, in a separate method step, the component (2, 2a; 12; 22; 32; 42) is adhesively attached.

5. Method according to at least one of the preceding claims, **characterized in that**, in a further method step, the electronic component (2, 2a; 12; 22; 32; 42) is at least partially coated with a preferably optically transparent protective layer (20; 30; 40).

6. Method according to Claim 5, **characterized in that** the protective layer (20; 30; 40) is applied to the electronic component (2, 2a; 12; 22; 32; 42) and at least partially removed before electrical contact is established.

7. Method according to Claim 5, **characterized in that** the protective layer (20; 30; 40) is applied as a film to the surface structure (1; 11; 21; 31; 41) and the electronic component (2, 2a; 12; 22; 32; 42) applied thereto, in particular is rolled on or sprayed on as a setting liquid.

8. Method according to at least one of the preceding claims, **characterized in that** the electronic components (2, 2a; 12; 22; 32; 42) are applied to the surface structure (1; 11; 21; 31; 41) in a regular pattern, preferably next to one another with a spacing.

9. Use of an embroidering machine, in particular a shuttle embroidering machine, for embroidering on at least one conductive track and for applying, fastening and establishing contact for at least one electronic component (2, 2a; 12; 22; 32; 42), in particular a photovoltaic cell or a solar module, on a flexible surface structure (1; 11; 21; 31; 41), at least one first conductive track establishing contact only with a first surface segment, in particular the underside, of the component (2, 2a; 12; 22; 32; 42), and at least one second conductive track establishing contact only with a second surface segment, in particular the upper side, of the same component (2, 2a; 12; 22; 32; 42).

10. Flexible surface structure with at least one electronic component, in particular a photovoltaic cell or a solar module, and at least one electrical conductive track that is embroidered, in particular by the double-thread system, **characterized in that** a first conductive track (4; 14; 24; 34; 44) establishes contact only with a first surface segment, in particular the underside, of the component (2, 2a; 12; 22; 32) and a second conductive track (5; 15; 25; 35; 45) establishes contact only with a second surface segment, in particular the upper side (7; 17), of the same component (2, 2a; 12; 22; 32; 42).

11. Flexible surface structure according to Claim 10, **characterized in that** the at least one component (2, 2a; 12; 22; 32; 42) is embroidered securely in place on the surface structure (1; 11; 21; 31; 41), in particular by the double-thread system.

12. Flexible surface structure according to Claim 10 or 11, **characterized in that** a protective layer (20; 30; 40), which covers at least the second surface segment, in particular the upper side, of the at least one component (2, 2a; 12; 22; 32; 42), is provided.

13. Flexible surface structure according to at least one of Claims 10 to 12, **characterized in that** a multiplicity of components (2, 2a; 12; 22; 32; 42) connected in series to one another in an electrically conducting manner are provided, together forming in particular at least one solar module.

14. Flexible surface structure according to at least one of Claims 10 to 13, **characterized in that** the conductive tracks (4, 5; 14, 15; 24, 25; 34, 35; 44, 45) contain silver or copper threads.

15. Flexible surface structure according to at least one of Claims 11 and 12, **characterized in that** the at least one component (2, 2a; 12; 22; 32; 42) is over-embroidered and/or embroidered on by means of nonconducting threads.

16. Flexible surface structure according to at least one of Claims 10 or 12 to 14, **characterized in that** the at least one component (2, 2a; 12; 22; 32; 42) is adhesively attached.

17. Flexible surface structure according to at least one of Claims 10 to 16, **characterized in that** the at least one component (2, 2a; 12; 22; 32; 42) has a greatest surface diameter of between 3 mm and 30 mm, in particular greater than 10 mm and up to 25 mm, or in particular of approximately 6 mm.

## Revendications

1. Procédé d'application d'au moins un composant électronique plat, en particulier d'une pile photovoltaïque ou d'un module solaire, sur une structure plane flexible, **caractérisé en ce que** pour le contact électriquement conducteur du composant électronique plat appliqué sur la structure plane flexible
(i) au moins une première piste conductrice (4 ; 14 ; 24 ; 34 ; 44) est d'abord appliquée,
(ii) celle-ci est mise en contact électriquement conducteur avec un premier segment de surface, en particulier le côté inférieur (16 ; 36 ; 46) du composant électronique (2, 2a ; 12 ; 22 ; 32 ; 42) et
(iii) ensuite au moins une deuxième piste conductrice (5 ; 15 ; 25 ; 35 ; 45) est appliquée, laquelle est mise en contact électriquement conducteur avec un deuxième segment de surface, en particulier le côté supérieur (7 ; 17), du même composant électronique (2, 2a ; 12 ; 22 ; 32 ; 42),
au moins une piste conductrice (4, 5 ; 14, 15 ; 24, 25 ; 34, 35 ; 44, 45) étant brodée, en particulier par une technique de broderie commandée par programme, en particulier au moyen d'une machine à broder à navettes.

2. Procédé selon la revendication 1, **caractérisé en ce que** le composant électronique (2, 2a ; 12 ; 22 ; 32 ; 42) est appliqué et fixé par une technique de brodage commandée par programme, en particulier au moyen d'une machine à broder à navettes.

3. Procédé selon la revendication 1 ou 2, **caractérisé en ce que** dans une étape de procédé séparée, le composant (2, 2a ; 12 ; 22 ; 32 ; 42), est brodé au moyen de fils non conducteurs (3 ; 13).

4. Procédé selon la revendication 1, **caractérisé en ce que** dans une étape de procédé séparée, le composant (2, 2a ; 12 ; 22 ; 32 ; 42) est collé.

5. Procédé selon au moins l'une quelconque des revendications précédentes, **caractérisé en ce que** dans une étape de procédé supplémentaire, le composant électronique (2, 2a ; 12 ; 22 ; 32 ; 42) est au moins en partie recouvert d'une couche de protection (20 ; 30 ; 40) de préférence laissant passer la lumière.

6. Procédé selon la revendication 5, **caractérisé en ce que** la couche de protection (20 ; 30 ; 40) est appliquée sur le composant électronique (2, 2a ; 12 ; 22 ; 32 ; 42) et est au moins en partie enlevée avant la mise en contact électrique.

7. Procédé selon la revendication 5, **caractérisé en ce que** la couche de protection (20 ; 30 ; 40) est appliquée sous forme de film sur la structure plane (1 ; 11 ; 21 ; 31 ; 41) et le composant électronique appliqué sur celle-ci (2, 2a ; 12 ; 22 ; 32 ; 42), en particulier par laminage ou par pulvérisation sous forme de liquide durcissant.

8. Procédé selon au moins l'une quelconque des revendications précédentes, **caractérisé en ce que** les composants électroniques (2, 2a ; 12 ; 22 ; 32 ; 42) sont appliqués suivant un motif régulier, de préférence à distance les uns à côté des autres, sur la structure plane (1 ; 11 ; 21 ; 31 ; 41).

9. Utilisation d'une machine à broder, en particulier d'une machine à broder à navettes, pour le brodage d'au moins une piste conductrice et pour l'application, la fixation et la mise en contact d'au moins un composant électronique (2, 2a ; 12 ; 22 ; 32 ; 42), en particulier d'une pile photovoltaïque ou d'un module solaire, sur une structure plane flexible (1 ; 11 ; 21 ; 31 ; 41), au moins une première piste conductrice venant en contact avec seulement un premier segment de surface, en particulier le côté inférieur, du composant (2, 2a ; 12 ; 22 ; 32 ; 42) et au moins une deuxième piste conductrice venant en contact avec seulement un deuxième segment de surface, en particulier le côté supérieur, du même composant (2, 2a ; 12 ; 22 ; 32 ; 42).

10. Structure plane flexible comprenant au moins un composant électronique, en particulier une pile photovoltaïque ou un module solaire, et au moins une piste conductrice électrique brodée, notamment dans un système à deux fils, **caractérisée en ce qu'**une première piste conductrice (4 ; 14 ; 24 ; 34 ; 44) vient en contact avec seulement un premier segment de surface, en particulier le côté inférieur, du composant (2, 2a ; 12 ; 22 ; 32) et une deuxième piste conductrice (5 ; 15 ; 25 ; 35 ; 45) vient en contact avec seulement un deuxième segment de surface, en particulier le côté supérieur (7 ; 17), du même composant (2, 2a ; 12 ; 22 ; 32 ; 42).

11. Structure plane flexible selon la revendication 10, **caractérisée en ce que** l'au moins un composant (2, 2a ; 12 ; 22 ; 32 ; 42) est fixé par brodage sur la structure plane (1 ; 11 ; 21 ; 31 ; 41), en particulier dans un système à deux fils.

12. Structure plane flexible selon la revendication 10 ou 11, **caractérisée en ce qu'**une couche de protection (20 ; 30 ; 40) est prévue, laquelle recouvre au moins le deuxième segment de surface, en particulier le côté supérieur, de l'au moins un composant (2, 2a ; 12 ; 22 ; 32 ; 42).

13. Structure plane flexible selon au moins l'une quelconque des revendications 10 à 12, **caractérisée en ce qu'**il est prévu une pluralité de composants (2, 2a ; 12 ; 22 ; 32 ; 42) connectés de manière électriquement conductrice les uns aux autres en série et/ou en rangée, lesquels forment notamment ensemble au moins un module solaire.

14. Structure plane flexible selon au moins l'une quelconque des revendications 10 à 13, **caractérisée en ce que** les pistes conductrices (4, 5 ; 14, 15 ; 24, 25 ; 34, 35 ; 44, 45) contiennent des fils d'argent ou de cuivre.

15. Structure plane flexible selon au moins l'une quelconque des revendications 11 à 12, **caractérisée en ce que** l'au moins un composant (2, 2a ; 12 ; 22 ; 32 ; 42) est brodé par-dessus et/ou brodé au moyen de fils non conducteurs.

16. Structure plane flexible selon au moins l'une quelconque des revendications 10 ou 12 à 14, **caractérisée en ce que** l'au moins un composant (2, 2a ; 12 ; 22 ; 32 ; 42) est collé.

17. Structure plane flexible selon au moins l'une quelconque des revendications 10 à 16, **caractérisée en ce que** l'au moins un composant (2, 2a ; 12 ; 22 ; 32 ; 42) présente un diamètre de surface maximal compris entre 3 mm et 30 mm, en particulier supérieur à 10 mm et pouvant aller jusqu'à 25 mm ou notamment d'environ 6 mm.
